# EUROPEAN PATENT APPLICATION

(11) **EP 4 661 637 A1**
(43) Date of publication of application: **10.12.2025**
(21) Application number: 25180131.2
(22) Date of filing: 02.06.2025
(51) Int. Cl.: H10K 59/12, H10K 59/80, H10K 77/10

(54) **DISPLAY DEVICE AND ELECTRONIC DEVICE INCLUDING THE SAME**

(30) Priority: 04.06.2024 KR 20240073061
(71) Applicant: Samsung Display Co., Ltd., Yongin-si, Gyeonggi-do 17113 (KR)
(72) Inventor: CHOI, Wonwoo, 17113 Giheung-Gu, Yongin-si, Gyeonggi-Do (KR); PARK, Beomsoo, 17113 Giheung-gu, Yongin-si, Gyeonggi-do (KR); LIM, Eunji, 17113 Giheung-Gu, Yongin-si, Gyeonggi-Do (KR)
(74) Representative: Dr. Weitzel & Partner

(57) **Abstract**

A display device includes: a first organic base layer comprising a plurality of element areas and a boundary area between the plurality of element areas; a plurality of inorganic layers on the first organic base layer with an opening defined therein, the opening exposing the first organic base layer and corresponding to the boundary area; an organic pattern in the opening and contacting the first organic base layer; a metal pattern inside the opening to contact the organic pattern and on the plurality of inorganic layers; at least one organic layer covering the metal pattern and on the plurality of inorganic layers; a first and a second transistor between the first organic base layer and the at least one organic layer and in the plurality of element areas; and a light-emitting element on the at least one organic layer and electrically connected to the first or second transistor.

## Description

### BACKGROUND

The present invention relates to a display device, and for example, to a flexible display device.

Electronic devices such as smartphones, tablets, notebook computers, navigators for vehicles, and smart televisions are being developed. Such electronic devices are provided with display devices for providing information.

Various types of display devices are being developed to satisfy user UXs/Uls. Among them, flexible display devices are being actively developed.

The above information disclosed in this Background section is only for enhancement of understanding of the background and therefore the information discussed in this Background section does not necessarily constitute prior art.

### SUMMARY

Aspects of some embodiments of the present invention include a display device with relatively improved impact resistance and relatively reduced defects.

The invention is defined by the features of claim 1. The dependent claims and description provide preferred embodiments of the invention.

According to the present invention a display device includes a first organic base layer, or just "organic base layer", including a plurality of element areas and boundary areas between the plurality of element areas, a plurality of inorganic layers on the first organic base layer and having an opening defined therein, wherein the opening exposes the first organic base layer and correspond to the boundary areas, an organic patterns in the openings and contacting the first organic base layer, a metal pattern partially inside the opening to contact the organic pattern and on the plurality of inorganic layers, at least one organic layer covering the metal pattern and on the plurality of inorganic layers, a first transistor and a second transistor between the first organic base layer and the at least one organic layer and in each of the plurality of element areas, and a light-emitting element on the at least one organic layer and electrically connected to at least the first transistors or the second transistors.

According to some embodiments, the plurality of inorganic layers may include an inorganic laminate structure in each of the plurality of element areas and defined by the opening and the opening surround the inorganic laminate structures in a plan view.

According to some embodiments, each of the plurality of element areas may include a first pixel area and a second pixel area, the first transistor and the second transistor may be in each of the first pixel area and the second pixel area; and the light-emitting elements may be in each of the first pixel area and the second pixel area.

According to some embodiments, the light-emitting elements may overlap with the opening in a plan view.

According to some embodiments, the display device may further include an inorganic base layer under the first organic base layer and a second (or further) organic base layer under the inorganic base layer, wherein a groove extending from the opening is defined in the first organic base layer.

According to some embodiments, the organic patterns may be in the groove.

According to some embodiments, the plurality of inorganic layers may include inner surface defining the opening and the metal pattern may contact the inner surface and an upper surface of a top inorganic layer of the plurality of inorganic layer.

According to some embodiments, the first transistor may include a silicon semiconductor pattern including a first input area, a first output area, and a first channel area between the first input area and the first output area, and the second transistor may include an oxide semiconductor pattern including a second input area, a second output area, and a second channel area between the second input area and the second output area.

According to some embodiments, the silicon semiconductor pattern and the oxide semiconductor pattern may be at different layers among the plurality of inorganic layers, and a first contact hole exposing the first input area or the first output area and a second contact hole exposing the second input area or the second output area may be defined in the plurality of inorganic layers.

According to some embodiments, the first contact hole may be deeper than the second contact hole, and the opening may be deeper than the first contact hole and the second contact hole.

According to some embodiments, the display device may further include a first connection electrode on the plurality of inorganic layers and connected to the first input area or the first output area through the first contact hole, and a second connection electrode on the plurality of inorganic layers and connected the second input area or the second output area through the second contact hole.

According to some embodiments, the first connection electrode, the second connection electrode, and the metal pattern may have the same laminate structure.

According to some embodiments, the metal pattern may include multilayer metal layers.

According to some embodiments, in a plan view, the metal pattern may cover the boundary area and expose a partial area of each of the plurality of element areas.

According to some embodiments, the display device may further include a thin-film encapsulation layer covering the light-emitting elements, an input sensor on the thin-film encapsulation layer, and a color filter on the input sensor and overlapping with the light-emitting element.

According to some embodiments, the display device may be foldable or rollable on a roller.

According to some embodiments of the present invention, a display device includes a base layer including a first element area, a second element area, and a boundary area between the first element area and the second element area, a plurality of inorganic layers having an opening defined therein, wherein the opening corresponds to the boundary area and extends from a top inorganic layer of the plurality of inorganic layers to the base layer in a plan view, an organic pattern in the opening and contacting the base layer, a metal pattern, a portion of which being inside the opening to contact the organic pattern and another portion of which being on the top inorganic layer, at least one organic layer covering the metal pattern and on the plurality of inorganic layers, transistor in each of the first element area and the second element area, and a light-emitting element on the at least one organic layer and electrically connected to the transistor.

According to some embodiments, in a plan view, the boundary area may surround each of the first element area and the second element area.

According to some embodiments, a groove extending from the opening may be defined in the base layer, and the organic pattern may be inside the groove.

According to some embodiments, a contact hole exposing a semiconductor patters of the transistor may be defined in the plurality of inorganic layers, and the opening may be deeper than the contact hole.

### BRIEF DESCRIPTION OF THE DRAWINGS

The accompanying drawings are included to provide a further understanding of the present invention, and are incorporated in and constitute a part of this specification. The drawings illustrate embodiments of the present invention and, together with the description, serve to explain principles of the present invention. In the drawings:
FIGS. 1A to 1C are perspective views of an electronic device according to some embodiments of the present invention;
FIG. 2 is an exploded perspective view of an electronic device according to some embodiments of the present invention;
FIG. 3 is a plane view of a display panel according to some embodiments of the present invention;
FIG. 4A is an equivalent circuit diagram of a pixel according to some embodiments of the present invention;
FIG. 4B is a plan view of a display area according to some embodiments of the present invention;
FIG. 4C is a cross-sectional view of a display module according to some embodiments of the present invention;
FIG. 4D is an enlarged cross-sectional view of a portion of a display panel according to some embodiments of the present invention;
FIG. 4E is a plan view illustrating disposition of metal patterns on a display area of a display panel according to some embodiments of the present invention;
FIG. 5 is an enlarged cross-sectional view of a portion of a display panel according to some embodiments of the present invention;
FIGS. 6A to 6D are cross-sectional views illustrating a manufacturing process of a display panel according to some embodiments of the present invention;
FIG. 7 is a cross-sectional view of a display module according to some embodiments of the present invention; and
FIGS. 8A and 8B are plan views of a display area according to some embodiments of the present invention.

### DETAILED DESCRIPTION

It will be understood that when an element or layer is referred to as being "on", "connected to" or "coupled to" another element or layer, it can be directly on, connected or coupled to the other element or or intervening third elements may be present.

Like reference numerals in the drawings refer to like elements. In addition, in the drawings, the thickness and the ratio and the dimension of the element are exaggerated for effective description of the technical contents. The term "and/or" includes any and all combinations of one or more of the associated items.

Terms such as first, second, and the like may be used to describe various components, but these components should not be limited by the terms. Such terms are only used for distinguishing one element from other elements. For instance, a first component may be referred to as a second component, or similarly, a second component may be referred to as a first component, without departing from the scope of the present invention. The singular expressions include plural expressions unless the context clearly dictates otherwise.

In addition, the terms such as "under", "lower", "on", and "upper" are used for explaining associations of items illustrated in the drawings. The terms are used as a relative concept and are described with reference to the direction indicated in the drawings.

It should be understood that the terms "comprise" or "have" are intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which example embodiments belong. In addition, it will be further understood that terms, such as those defined in commonly-used dictionaries, should be interpreted as having a meaning that is consistent with their meaning in the context of the relevant art and will not be interpreted in an idealized or overly formal sense unless expressly so defined herein.

Hereinafter, embodiments of the present invention will be described with reference to the accompanying drawings.

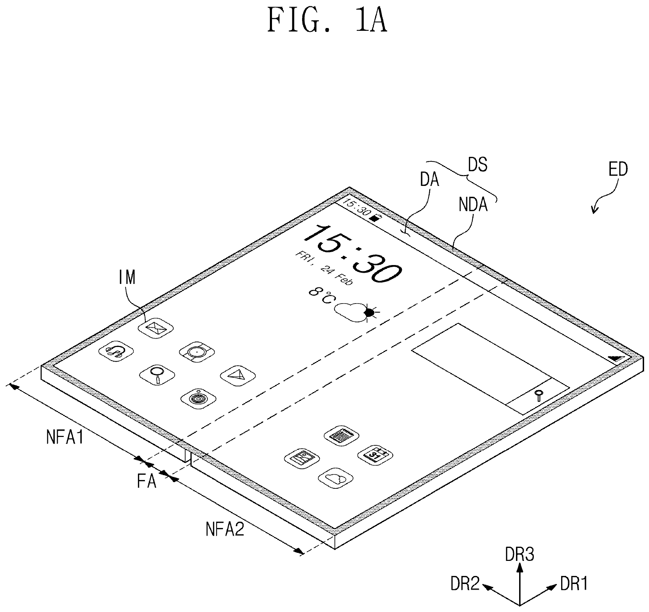

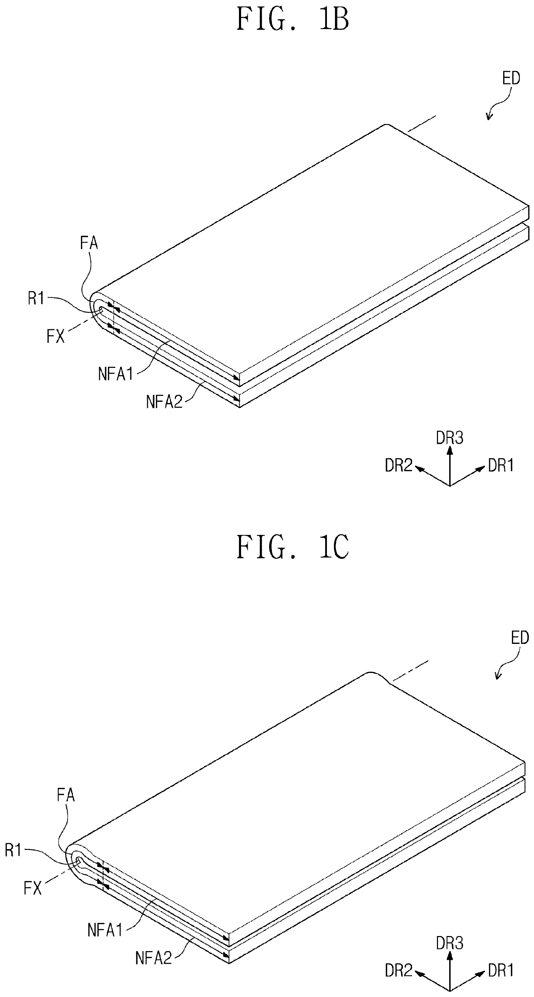

FIGS. 1A to 1C are perspective views of an electronic device ED according to some embodiments of the present invention. FIG. 1A shows an unfolded state and FIGS. 1B and 1C show a folded state.

Referring to FIGS. 1A to 1C, the electronic device ED according to some embodiments may include a display surface DS defined by a first direction DR1 and a second direction DR2 crossing the first direction DR1. The electronic device ED may provide a user with an image IM through the display surface DS.

The display surface DS may includes a display area DA and a non-display area NDA around the display area DA. The display area DA may display the image IM, and the non-display area NDA may not display the image IM. The non-display area NDA may surround the display area DA. However, the embodiments of the present invention are not limited thereto, and the shapes of the display area DA and the non-display area NDA may be modified.

Hereinafter, a direction, which substantially vertically crosses the plane defined by the first and second directions DR1 and DR2, is defined as a third direction DR3. The third direction DR3 may serve as the basis for distinguishing between a front surface (or a top surface) and a rear surface (or a bottom surface) of each member. In the specification, "in a plan view" may refer to the state when viewed in the third direction DR3. Hereinafter, the first to third directions DR1, DR2, and DR3 refer to like reference numerals indicated by first to third directional axes, respectively.

The electronic device ED may include a folding area FA and a plurality of non-folding areas NFA1 and NFA2. The non-folding areas NFA1 and NFA2 may include a first non-folding area NFA1 and a second non-folding area NFA2. In the second direction DR2, the folding area FA may be located between the first non-folding area NFA1 and the second non-folding area NFA2.

The electronic device ED in a first mode may be defined as an unfolded state, and the electronic device ED in a second mode may be defined as a folded state. As the mode of the electronic device ED changes from the first mode to the second mode, the shape of the folding area FA changes, but the shapes of the non-folding areas NFA1 and NFA2 do not change.

As shown in FIG. 1B, the folding area FA may be folded on the basis of a folding axis FX parallel to the first direction DR1. The folding area FA has a prescribed curvature and a radius R1 of curvature. The first non-folding area NFA1 and the second non-folding area NFA2 may be opposite to each other, and the electronic device ED may be inner-folded so that the display surface DS is not exposed to the outside.

According to some embodiments of the present invention, the electronic device ED may be outer-folded so that the display surface DS is exposed to the outside. According to some embodiments of the present invention, the electronic device ED may be configured so that an inner-folding operation and an outer-folding operation are alternately repeated from an unfolding operation, but the embodiments are not limited thereto. According to some embodiments of the present invention, the electronic device ED may be configured to select any one among the unfolding operation, the inner-folding operation, or the outer-folding operation.

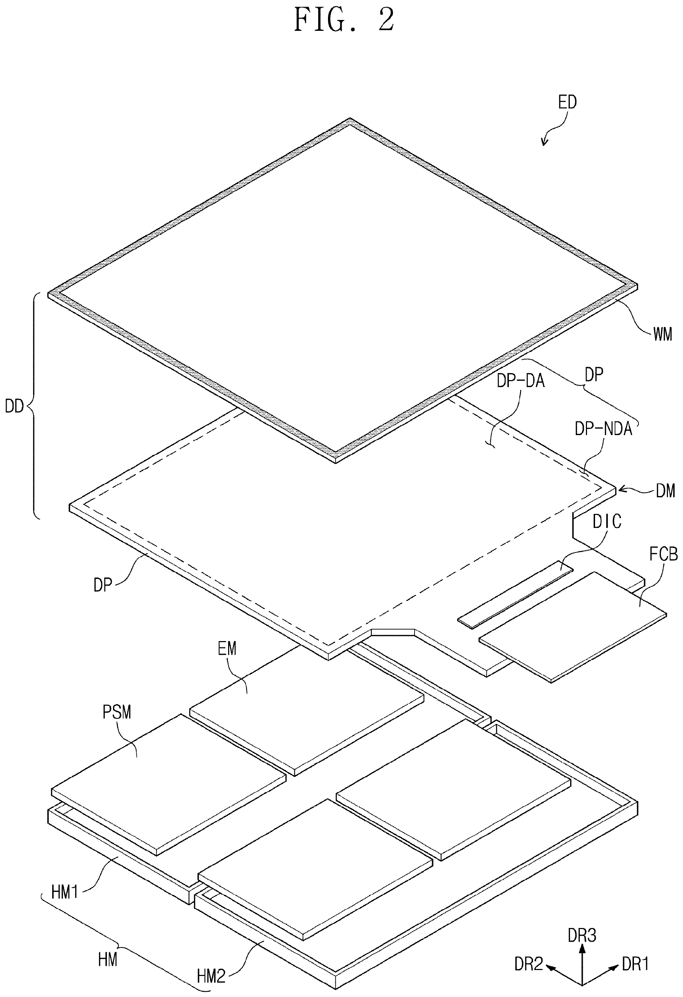

As shown in FIG. 1B, the distance between the first non-folding area NFA1 and the second non-folding area NFA2 may be substantially the same as double the radius R1 of the curvature, but as shown in FIG. 1C, the distance between the first non-folding area NFA1 and the second non-folding area NFA2 may be smaller than double the radius R1 of the curvature. The distance between the first non-folding area NFA1 and the second non-folding area NFA2 described in FIGS. 1B and 1C are measured on the basis of the display surface DS. The folded portions of a housing HM (see FIG. 2) providing the appearance of the folded electronic device ED may contact to each other.

FIGS. 1A to 1C show example foldable electronic devices, but the display device according to some embodiments of the present invention may also be applied to an electronic device other than the foldable electronic devices. The display device according to some embodiments may also be applied to a rollable electronic device including a roller or a planar electronic device. The display device according to some embodiments of the present invention may also be applied to a medium or large scale electronic device other than a small electronic device such as a hand-held phone.

FIG. 2 is an exploded perspective view of the electronic device ED according to some embodiments of the present invention.

As shown in FIG. 2, the electronic device ED may include a display device DD, an electronic module EM, a power supply module PSM, and the housing HM. According to some embodiments, the electronic device ED may further include a mechanism structure for controlling the folding operation of the display device DD.

The display device DD generates an image and detects an external input. The display device DD includes a window WM and a display module DM. The window WM provides the front surface of the electronic device ED.

The display module DM may include at least a display panel DP. FIG. 2A illustrates only the display panel DP in a laminate structure of the display module DM, but in substance, the display module DM may further include a plurality of components located over or under the display panel DP. For example, the display module DM may further include an input sensor, a protection film, or a polarization film over the display panel DP. The display module DM may further include a support member or heat-dissipating member located under the display panel DP. The display panel DP is not particularly limited, and may be, for example, an emissive display panel such as an organic light-emitting display panel or an inorganic light-emitting display panel.

The display panel DP may include a display area DP-DA and a non-display area DP-NDA corresponding to the display area DA (see FIG. 1A) and non-display area NDA (see FIG. 1A) of the electronic device ED. In the specification, "an area/portion corresponds to an area/portion" means overlapping each other, and is not limited to having the same area.

As shown in FIG. 2, a driving chip DIC may be located on the non-display area DP-NDA of the display panel DP. A flexible circuit board FCB may be coupled to the non-display area DP-NDA of the display panel DP. The flexible circuit board FCB may be connected to a main circuit board. The main circuit board may be an electronic component configuring the electronic module EM.

The driving chip DIC may include a data driving circuit, for example, driving elements for driving pixels of the display panel DP. FIG. 2 illustrates a structure in which the driving chip DIC is mounted on the display panel DP, but the embodiments of the present invention are not limited thereto. For example, the driving chip DIC may be directly mounted on the flexible circuit board FCB.

The electronic module EM may drive the display device DD. The electronic module EM is electrically connected to the driving chip DIC. The electronic module EM may include a control module, a wireless communication module, an image input module, a sound input module, a sound output module, a memory, an external interface module or the like. The electronic module EM may include the main circuit board, and the modules may be mounted on the main circuit board or electrically connected to the main circuit board via the flexible circuit board FCB. The electronic module EM is electrically connected to the power supply module PSM. The power supply module PSM may supply a power to the display device and the electronic module, respectively.

Referring to FIG. 2, the electronic module EM may be divided and respectively located in a first housing HM1 and a second housing HM2, and the power supply module PSM may also be divided and respectively located in the first housing HM1 and the second housing HM2. According to some embodiments, the electronic module EM divided and respectively located in the first housing HM1 and the second housing HM2 may be electrically connected via the flexible circuit board FCB.

According to some embodiments, the electronic device ED may further include an electro-optical module. The electro-optical module may be an electronic component configured to output or receive an optical signal. The electro-optical module may include a camera module and/or a proximity sensor. The camera module may capture an external image through a partial area of the display panel DP.

The housing HM shown in FIG. 2 is coupled with the display device DD, in particular, the window WM to accommodate the other modules. The housing HM is shown to include the first and second housings HM1 and HM2 that are spaced apart from each other, but is not limited thereto. According to some embodiments, the electronic device ED may further include a hinge structure for connecting the first and second housings HM1 and HM2.

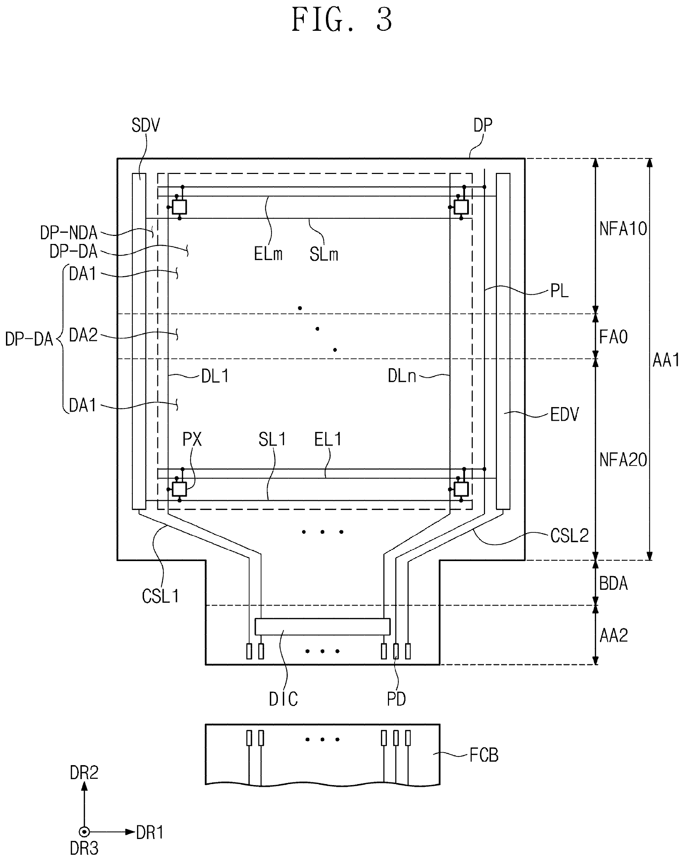

FIG. 3 is a plane view of the display panel DP according to some embodiments of the present invention.

Referring to FIG. 3, the display panel DP may include the display area DP-DA and the non-display area DP-NDA around the display area DP-DA. Pixels PX are located in the display area DP-DA. A scan driving unit SDV, a data driving unit, and an emission driving unit EDV may be located in the non-display area DP-NDA. The data driving unit may be a partial circuit configured in the driving chip DIC shown in FIG. 3.

The display panel DP may include a first area AA1, a second area AA2, and a bending area BDA divided in the second direction DR2. The second area AA2 and the bending area BDA may be partial areas of the non-display area DP-NDA. The bending area BDA is located between the first area AA1 and the second area AA2.

The first area AA1 corresponds to the display surface DS of FIG. 1A. The first area AA1 may include a first non-folding area NFA10, a second non-folding area NFA20, and a folding area FA0. The first non-folding area NFA10, the second non-folding area NFA20, and the folding area FA0 may respectively correspond to the first non-folding area NFA1, the second non-folding area NFA2, and the folding area FA of FIGS. 1A to 1C.

The display area DP-DA may include two first display areas DA1 corresponding to the first non-folding area NFA10 and the second non-folding area NFA20, and a second display area DA2 corresponding to the folding area FA0. The length of the bending area BDA and the second area AA2 in the second direction DR2 may be smaller than that of the first area AA1. An area in which the length in a bending axis direction is shorter may be bent more easily.

The display panel DP may include a plurality of pixels PX, a plurality of scan lies SL1 to SLm, a plurality of data lines DL1 to DLn, a plurality of emission lines EL1 to ELm, first and second control lines CSL1 and CSL2, a voltage line PL, and a plurality of pads PD. Here, m and n are natural numbers. The pixels PX may be electrically connected to the scan lines SL1 to SLm, the data lines DL1 to DLn, and the emission lines EL1 to ELm. The display panel DP may include a plurality of groups of scan lines, but FIG. 3 shows example scan lines SL1 to SLm of a first group.

The first group scan lines SL1 to SLm may extend in the first direction DR1 to be connected to the scan driver SDV. The data lines DL1 to DLn may extend in the second direction DR2 to be connected to the data driving chip DIC via the bending area BDA. The emission lines EL1 to ELm may extend in the first direction DR1 to be connected to the emission driving unit EDV.

The voltage line PL may include a portion extending in the second direction DR2 and a portion extending in the first direction DR1. The portion extending in the first direction DR1 and the portion extending in the second direction DR2 may be located on different layers. The portion extending in the second direction DR2 of the voltage line PL may extend to the second area AA2 via the bending area BDA. The voltage line PL may provide a first power supply voltage ELVDD to the pixels PX.

The first control line CSL1 may be connected to the scan driving unit SDV, and extend towards the lower end of the second area AA2 via the bending area BDA. The second control line CSL2 may be connected to the emission driving unit EDV and extend towards the lower end of the second area AA2 via the bending area BDA.

In a plan view, the pads PD may be located adjacent to the lower end of the second area AA2. The driving chip DIC, the voltage line PL, the first control line CSL1, and the second control line CSL2 may be connected to the pads PD. The flexible circuit board FCB may be electrically connected to the pads PD via an anisotropic conductive adhesive layer.

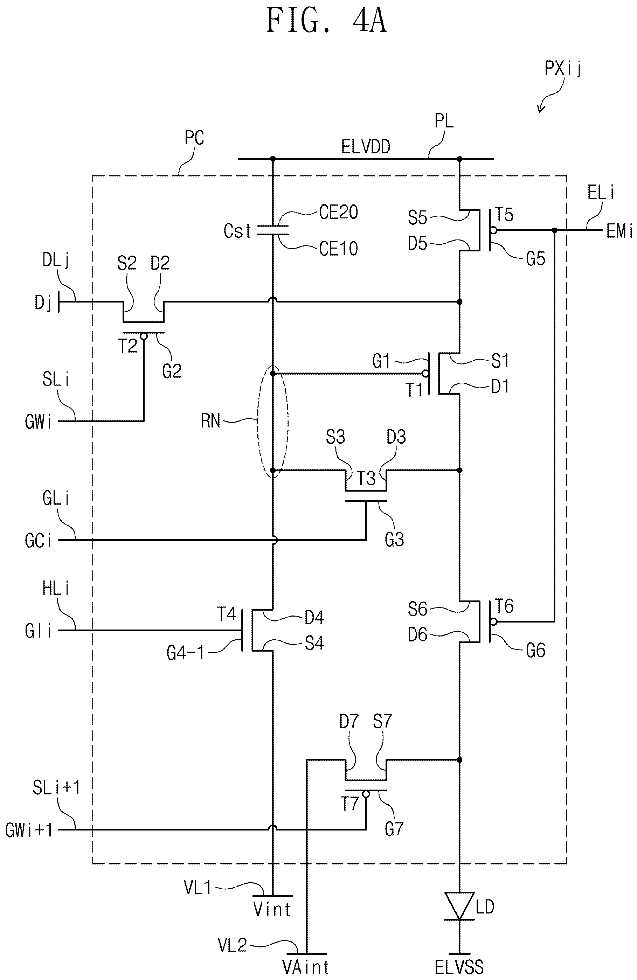

FIG. 4A is an equivalent circuit diagram of a pixel PXij according to some embodiments of the present invention. Although FIG. 4A illustrates various components in a pixel according to some embodiments, embodiments according to the present invention are not limited thereto, and according to some embodiments, the pixel may include additional components or fewer components without departing from the scope of embodiments according to the present invention.

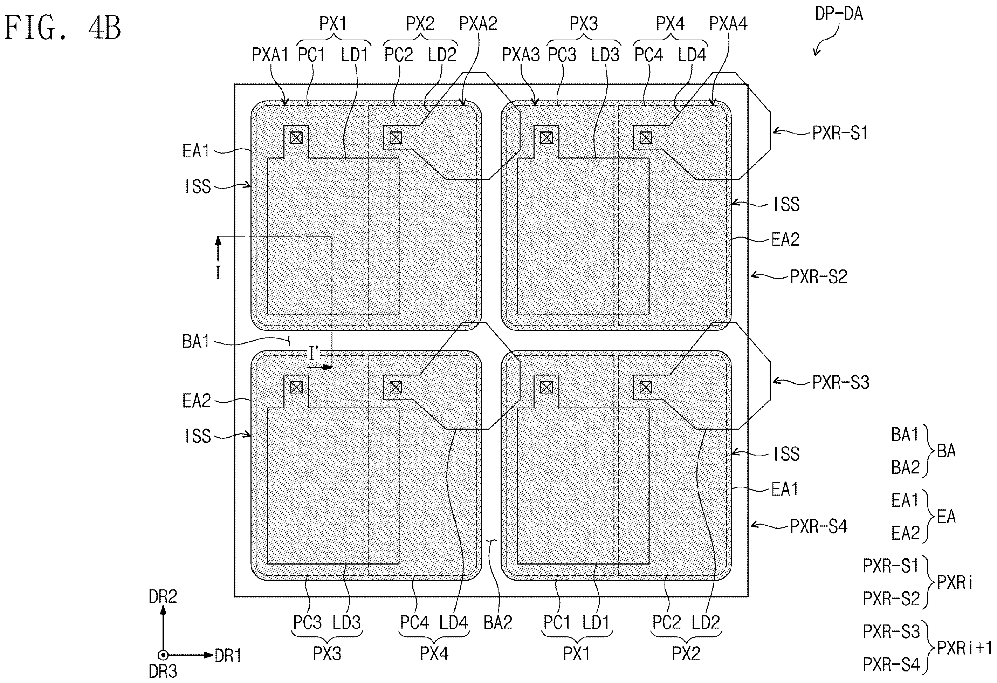

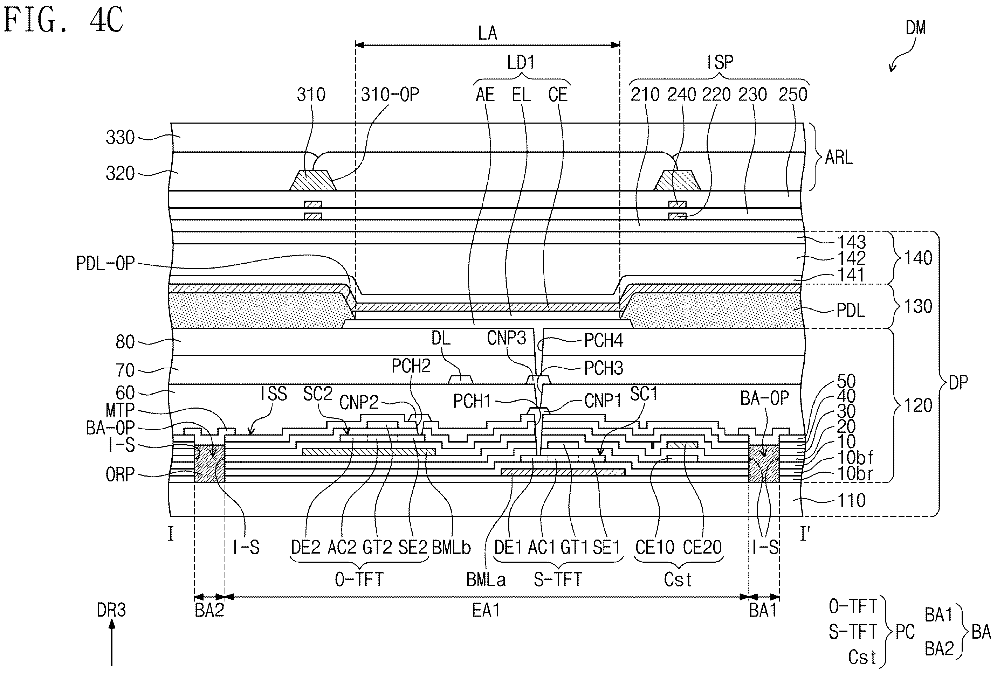

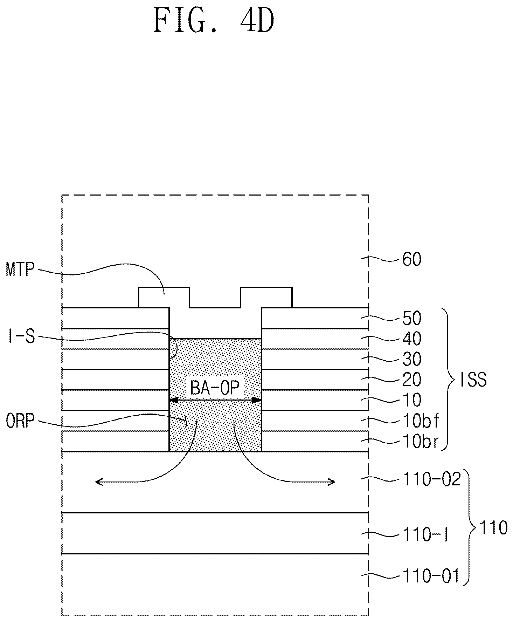

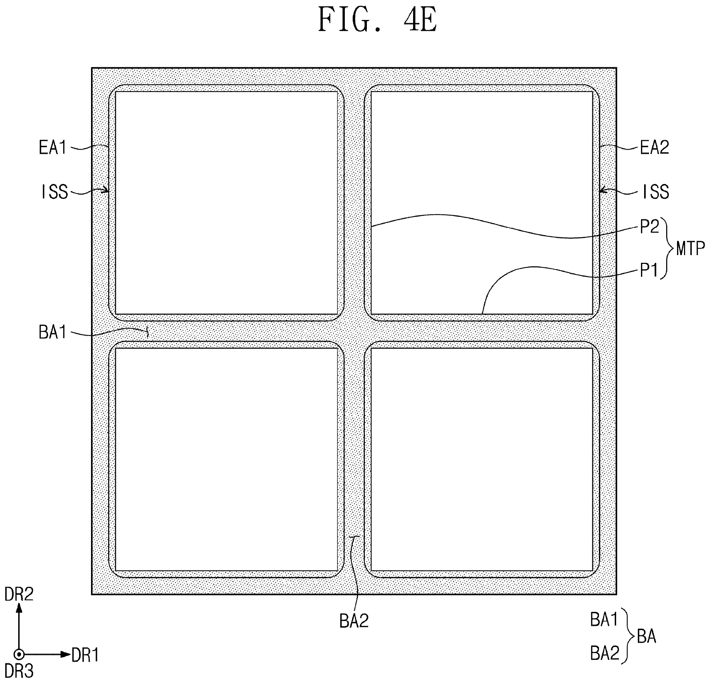

FIG. 4B is a plan view of the display area DP-DA according to some embodiments of the present invention. FIG. 4C is a cross-sectional view of the display module DM according to some embodiments of the present invention. FIG. 4D is an enlarged cross-sectional view of the display panel DP according to some embodiments of the present invention. FIG. 4E is a plan view showing a disposition of metal pattern MTP in the display area DP-DA of the display panel DP according to some embodiments of the present invention.

FIG. 4A shows the example pixel PXij connected to an i-th scan line SLi among the first group scan lines SL1 to SLm of FIG. 3 and a j-th data line DLj among the plurality of data lines DL1 to DLn of FIG. 3. The pixel PXij may include a pixel driving circuit PC and a light-emitting element LD. The light-emitting element LD may receive a second power supply voltage ELVSS.

According to some embodiments, the pixel driving circuit PC may include first to seventh transistors T1 to T7, and a capacitor Cst. According to some embodiments, the first transistor T1, the second transistor, and the fifth transistor T5 to the seventh transistor T7 are described to be P-type transistors, and the third transistor T3 and the fourth transistor T4 are described to be N-type transistors. However, the embodiments are not limited thereto, and each of the first to seventh transistors T1 to T7 may be implemented with any one of a P-type transistor or an N-type transistor. An input area (or an input electrode) of the N-type transistor is described as a drain (or a drain area), and an input area of the P-type transistor is described as a source (or a source area). An output area (or an output electrode) of the N-type transistor is described as a source (or a source area), and an output area of the P-type transistor is described as a drain (or a drain area). In addition, according to some embodiments of the present invention, at least one of the first to seventh transistors T1 to T7 may be omitted.

According to some embodiments, the first transistor T1 may be a driving transistor, and the second transistor T2 may be a switching transistor. The capacitor Cst is electrically connected between a reference node RN and a first voltage line PL configured to receive a first power supply voltage ELVDD higher than the second power supply voltage ELVSS. The capacitor Cst includes a first electrode CE10 electrically connected to the reference node RN and a second electrode CE20 electrically connected to the first voltage line PL.

The first transistor T1 is electrically connected between the first voltage line PL and one electrode (e.g., an anode) of the light-emitting element LD. A source S1 of the first transistor T1 is electrically connected to the first voltage line PL. In the specification, "to be electrically connected between a transistor and a signal line or between transistors" means that "a source, drain, and gate of the transistor have an integrated shape with the signal line, or are connected to the signal line via connection electrodes". Another transistor may be located between the source S1 of the first transistor T1 and the first voltage line PL or may be omitted.

The drain D1 of the first transistor T1 is electrically connected to the anode of the light-emitting element LD. Another transistor may be located between a drain D1 of the first transistor T1 and the anode of the light-emitting element LD or may be omitted. A gate G1 of the first transistor T1 is electrically connected to the reference node RN.

The second transistor T2 is electrically connected between a j-th data line DLj and the source S1 of the first transistor T1. The source S2 of the second transistor T2 is electrically connected to the j-th data line DLj, and a drain D2 of the second transistor T2 is electrically connected to the source S1 of the first transistor T1. According to some embodiments, a gate G2 of the second transistor T2 may be electrically connected to an i-th scan line SLi of the first group.

The third transistor T3 is electrically connected between the reference node RN and the drain D1 of the first transistor T1. A drain D3 of the third transistor T3 is electrically connected to the drain D1 of the first transistor T1, and a source S3 of the third transistor T3 is electrically connected to the reference node RN. The third transistor T3 is illustrated as having a single gate, but the third transistor T3 may include a plurality of gates. According to some embodiments, the gate G3 of the third transistor T3 may be electrically connected to an i-th scan line GLi of a second group. The fourth transistor T4 is electrically connected between the reference node RN and a second voltage line VL1. A drain D4 of the fourth transistor T4 is electrically connected to the reference node RN, and a source S4 of the fourth transistor T4 is electrically connected to the second voltage line VL1. The fourth transistor T4 is illustrated as having a single gate, but the fourth transistor T4 may include a plurality of gates. According to some embodiments, the gate G4 of the fourth transistor T4 may be electrically connected to an i-th scan line HLi of a third group.

The fifth transistor T5 is electrically connected between the first voltage line PL and the source S1 of the first transistor T1. A source S5 of the fifth transistor T5 is electrically connected to the first voltage line PL, and a drain D5 of the fifth transistor T5 is electrically connected to the source S1 of the first transistor T1. A gate of the fifth transistor T5 may be electrically connected to the i-th emission line ELi.

The sixth transistor T6 is electrically connected between the light-emitting element LD and the drain D1 of the first transistor T1. A source S6 of the sixth transistor T6 is electrically connected to the drain D1 of the first transistor T1, and a drain D6 of the sixth transistor T6 is electrically connected to the anode of the light-emitting element LD. A gate G6 of the sixth transistor T6 may be electrically connected to the i-th emission line ELi. According to some embodiments of the present invention, the gate G6 of the sixth transistor T6 may be connected to a signal line different from the gate G5 of the fifth transistor T5.

The seventh transistor T7 is electrically connected between the light-emitting element and a third voltage line VL2. A source S7 of the seventh transistor T7 is electrically connected to the anode of the light-emitting element LD and the drain D6 of the sixth transistor T6, and a drain D7 of the seventh transistor T7 is electrically connected to the third voltage line VL2. A gate G7 of the seventh transistor T7 may be electrically connected to an (i+1)-th scan line SLi+1 of the first group.

When the emission control signal EMi has a high level, the fifth transistor T5 and the sixth transistor T6 are turned off. When the fifth and sixth transistors T5 and T6 are turned off, a current path is not provided between the first voltage line PL and the light-emitting element LD. Accordingly, the corresponding period may be defined as a non-emission period.

When a scan signal Gli is applied to an i-th scan line HLi of the third group, the fourth transistor T4 is turned on. When the fourth transistor T4 is turned on, the reference node RN is initialized by a first initialization voltage Vint.

When a scan signal GWi applied to the i-th scan line SLi of the first group has a low level and a scan signal GCi applied to the i-th scan line GLi of the second group has a high level, the second transistor T2 and the third transistor T3 are turned on. Because the reference node RN is initialized to the first initialization voltage Vint, the first transistor T1 is turned on. When the second transistor T2, the third transistor T3 and the first transistor T1 are turned on, and a voltage corresponding to a data signal Dj is provided to the reference node RN. Here, the capacitor Cst stores a voltage corresponding to the data signal Dj. The voltage corresponding to the data signal Dj may be a voltage of the data signal Dj reduced by a threshold voltage Vth of the first transistor T1.

When a scan signal GWi+1 applied to the (i+1)-th scan line SLi+1 of the first group has a low level, the seventh transistor T7 is turned on. As the seventh transistor T7 is turned on, the anode of the light-emitting element LD is initialized to a second initialization voltage VAint. Accordingly, a parasite capacitor of the light-emitting element LD may be discharged.

When the emission control signal EMi has a low level, the fifth transistor T5 and the sixth transistor T6 are turned on. When the fifth transistor T5 is turned on, the first power supply voltage ELVDD is provided to the first transistor T1. When the sixth transistor T6 is turned on, the first transistor T1 is electrically connected to the light-emitting element LD. The light-emitting element LD generates light of a prescribed luminance in correspondence to a received current amount.

FIG. 4B illustrates an enlarged portion of the display area DP-DA corresponding to two pixel rows PXRi and PXRi+1. The display area DP-DA may be the first display area DA1 or the second display area DA2 shown in FIG.3.

The display area DP-DA may include a plurality of element areas EA and boundary areas BA adjacent to the plurality of element areas EA. The plurality of element areas EA may include first type element areas EA1 and second type element areas EA2. The first type element areas EA1 and the second type element areas EA2 may be alternately arranged along the first direction DR1, or the second direction DR2.

The boundary areas BA may respectively surround the first type element areas EA1 and the second type element areas EA2. The boundary areas BA may include first boundary areas BA1 extending in the first direction DR1 and second boundary areas BA2 extending in the second direction DR2. The first boundary areas BA1 may intersect with the second boundary areas BA2 at a plurality of spots. According to some embodiments, "that the first boundary areas BA1 extend in the first direction DR1" is not limited to "that the widths of the first boundary areas BA1 are uniform". In areas between the first type element areas EA1 and the second type element areas EA2, the widths of the first boundary areas BA1 in the second direction DR2 may be uniform, but are not necessarily limited thereto.

The boundary areas BA may be defined by opening provided in the plurality of inorganic layers. A detailed description about the boundary areas BA will be provided below.

The i-th pixel row PXRi may include a first pixel PX1, a second pixel PX2, a third pixel PX3, and a fourth pixel PX4 arranged in the first direction DR1. The first pixel PX1, the second pixel PX2, the third pixel PX3, and the fourth pixel PX4 may be units of repetition in the i-th pixel row PXRi. The first pixel PX1, the second pixel PX2, the third pixel PX3, and the fourth pixel PX4 may respectively include pixel driving circuits PC1, PC2, PC3 and PC4 and light-emitting elements LD1, LD2, LD3 and LD4 electrically connected to the pixel driving circuits PC1, PC2, PC3 and PC4. Each of the pixel driving circuits PC1, PC2, PC3 and PC4 may be the same as a pixel driving circuit of FIG. 4A. FIG. 4B illustrates anodes of the light-emitting elements LD1, LD2, LD3 and LD4 on behalf of the light-emitting elements LD1, LD2, LD3 and LD4. In FIG. 4B, anodes of the first pixel PX1 and the third pixel PX3 are shown to have the same shape and area, and anodes of the second pixel PX2 and the fourth pixel PX4 are shown to have the same shape and area. However, the embodiments according to the present invention are not limited thereto. According to some embodiments of the present invention, the anode of the first pixel PX1 may have a smaller area than the anode of the third pixel PX3.

The first pixel PX1 may generate first color light, and the first color light may be red light. Each of the second pixel PX2 and the fourth pixel PX4 may generate second color light, and the second color light may be green light. The third pixel PX3 may generate third color light, and the third color light may be blue light. According to some embodiments, each of the plurality of element areas EA has two pixels configured to generate different rays of light, but is not limited thereto.

The first pixel PX1 and the second pixel PX2 are arranged corresponding to the first type element areas EA1, and the third pixel PX3 and the fourth pixel PX4 are arranged corresponding to the second type element areas EA2. The pixel driving circuit PC1 of the first pixel PX1 (hereinafter, a first pixel driving circuit) and the pixel driving circuit PC2 of the second pixel PX2 (hereinafter, a second pixel driving circuit) overlap the first type element areas EA1. The first pixel driving circuit PC1 and the second pixel driving circuit PC2 are located in different areas of the first type element areas EA1. An area in which the first pixel driving circuit PC1 is located may be defined as a first pixel area PXA1, and an area in which the second pixel driving circuit PC2 is located may be defined as a second pixel area PXA2. FIG. 4B shows an example case that the first type element areas EA1 are divided into the first pixel area PXA1 and the second pixel area PXA2 in the first direction DR1, but the example case is not limited thereto. The pixel area is an area in which the pixel driving circuit is actually located, and thus a boundary between the first pixel area PXA1 and the second pixel area PXA2 is not limited to a straight line.

The pixel driving circuit PC3 of the third pixel PX3 (hereinafter, a third pixel driving circuit) and the pixel driving circuit PC4 of the fourth pixel PX4 (hereinafter, a fourth pixel driving circuit) overlap the second type element area EA2. The third pixel driving circuit PC3 and the fourth pixel driving circuit PC4 are located in different areas of the second type element areas EA2. An area in which the third pixel driving circuit PC3 is located may be defined as a third pixel area PXA3, and an area in which the fourth pixel driving circuit PC4 is located may be defined as a fourth pixel area PXA4.

The light-emitting element LD2 of the second pixel PX2 (hereinafter, a second light-emitting element) and the light-emitting element LD4 of the fourth pixel PX4 (hereinafter, a fourth light-emitting element) are arranged in the first direction DR1 to define a first sub-pixel row PXR-S1, and the light-emitting element LD1 of the first pixel PX1 (hereinafter, a first light-emitting element) and the light-emitting element LD3 of the third pixel PX3 (hereinafter, a third light-emitting element) are arranged in the first direction DR1 to define a second sub-pixel row PXR-S2. An anode of the second light-emitting element LD2 and an anode of the fourth light-emitting element LD4 may partially overlap the boundary areas BA. However, the second pixel driving circuit PC2 and the fourth pixel driving circuit PC4 do not overlap the boundary areas BA. In other words, a silicon transistor S-TFTto be described below and an oxide transistor O-TFT to be described below do not overlap the boundary areas BA.

An (i+1)-th pixel row PXRi+1 may include the third pixel PX3, the fourth pixel PX4, the first pixel PX1, and the second pixel PX2 arranged in the first direction DR1. The second light-emitting element LD2 and the fourth light-emitting element LD4 may be arranged in the first direction DR1 to define a third sub-pixel row PXR-S3, and the third light-emitting element LD3 and the first light-emitting element LD1 may be arranged in the first direction DR1 to define a fourth sub-pixel row PXR-S4.

As shown in FIG. 4C, the display module DM may include the display panel DP, input sensor ISP located on the display panel DP, and an anti-reflection layer ARL on the input sensor ISP, although embodiments according to the present invention are not limited thereto, and according to some embodiments, the display module DM may include additional components or fewer components.

Referring to FIG. 4C, the pixel driving circuit PC may include a plurality of transistors and a capacitor. FIG. 4C illustrates the silicon transistor S-TFT and the oxide transistor O-TFT as example transistors. FIG. 4C shows a partial configuration of the pixel driving circuit PC shown in FIG. 4A. According to some embodiments of the present invention, the pixel driving circuit PC may also include only one kind of transistor between the silicon transistor S-TFT and the oxide transistor O-TFT. When the silicon transistor S-TFT is defined as a first transistor (or a first type transistor), the oxide transistor O-TFT may be defined as a second transistor) (or a second type transistor).

Referring to FIG. 4C, a base layer 110 is shown as a single layer. The base layer 110 may include at least one organic layer (hereinafter, an organic base layer). The organic base layer may include a synthetic resin such as polyimide. The first type element areas EA1 and the boundary areas BA described with reference to FIG. 4B may be defined on the base layer 110. Although layers located on the base layer 110 are not arranged in a partial area of the element areas EA and the boundary areas BA, the base layer 110 may be arranged in the entirety of the first type element areas EA1 and the boundary areas BA.

Referring to FIG. 4C, a barrier layer 10br may be located on the base layer 110. The barrier layer 10br prevents or reduces instances of foreign matter or contaminants entering from the outside. The barrier layer 10br may include at least one inorganic layer. The barrier layer 10br may include silicon oxide layers, silicon nitride layers, or silicon oxynitride layers. The barrier layer 10br may include silicon oxide layers and silicon nitride layers that are alternately laminated.

A first shield electrode BMLa may be located on the barrier layer 10br. The first shield electrode BMLa may be arranged corresponding to the silicon transistor S-TFT. The first shield electrode BMLa may include a metal.

The first shield electrode BMLa may receive a bias voltage. The first shield electrode BMLa may also receive the first power supply voltage. The first shield electrode BMLa may block an electric potential caused by a polarization phenomenon from influencing the silicon transistor S-TFT. The first shield electrode BMLa may block external light from reaching the silicon transistor S-TFT. According to some embodiments of the present invention, the first shield electrode BMLa may be a floating electrode isolated from another electrode or a wiring.

A buffer layer 10bf may be located on the barrier layer 10br. The buffer layer 10bf may cover the first shield electrode BMLa. The buffer layer 10bf may prevent or reduce a phenomenon in which metal atoms or impurities diffuse to an upper-side first semiconductor pattern SC1. The buffer layer 10bf may include at least one inorganic layer. The buffer layer 10bf may include silicon oxide layers, silicon nitride layers, or silicon oxynitride layers.

The first semiconductor pattern SC1 may be located on the buffer 1ayer 10bf. The first semiconductor pattern SC1 may include a silicon semiconductor. For example, the silicon semiconductor may include amorphous silicon, polycrystalline silicon, or the like. For example, the first semiconductor pattern SC1 may include low temperature polysilicon.

The first semiconductor pattern SC1 may have different electrical properties, depending on success or failure of doping. The first semiconductor pattern SC1 may include a first area having high conductivity and a second area having low conductivity. The first area may be doped with an N-type dopant or a P-type dopant. A P-type transistor includes a doped area doped with a P-type dopant, and an N-type transistor includes a doped area doped with an N-type dopant. The second area may be a non-doped area, or an area doped at a lower concentration relative to the first area. According to some embodiments, the first semiconductor pattern SC1 may be an N-type transistor.

The first area may have greater conductivity than the second area, and substantially serve as an electrode or a signal line. The second area may substantially correspond to a channel area (or an active area) of a transistor. In other words, a portion of the first semiconductor pattern SC1 may be a channel of the transistor, another portion may be the source or drain of the transistor, and still another portion may be a connection electrode or a signal connection line.

A source area SE1 (hereinafter a first source area), a channel area AC1 (or an active area, hereinafter a first channel area), and a drain area DE1 (hereinafter a first drain area) of the silicon transistor S-TFT be provided from the first semiconductor pattern SC1. The source area SE1 and the drain area DE1 may extend in opposite directions from the first channel area AC1 in a cross-sectional view.

The first insulation layer 10 may be located on the buffer 1ayer 10bf. The first insulation layer 10 may cover the first semiconductor pattern SC1. The first insulation layer 10 may be an inorganic layer. The first insulation layer 10 may be a single silicon oxide layer. Not only the first insulation layer 10 but also the inorganic layer of the driving element layer 120 to be described below may have a single layer or multilayer structure and include at least one of the above-described inorganic layers. However, the embodiments according to the present invention are not limited thereto.

A gate GT1 of the silicon transistor S-TFT is located on the first insulation layer 10. The gate GT1 may be partially a metal pattern. The gate GT1 may overlap with the first channel area AC1. The gate GT1 may serve as a mask in a process for doping the first semiconductor pattern SC1. A first electrode CE10 of the storage capacitor Cst is located on the first insulation layer 10. Unlike the shown in FIG. 4C, the first electrode CE10 may have an integrated shape with the gate GT1.

The second insulation layer 20 may be located on the first insulation layer 10 and cover the gate GT1. According to some embodiments of the present invention, an upper electrode overlapping with the gate GT1 may be further arranged on the second insulation layer 20. A second electrode CE20, which overlaps the first electrode CE10, may be located on the second insulation layer 20. The upper electrode and the second electrode CE20 may provide an integrated shape in a plan view.

A second shield electrode BMLa is located on the second insulation layer 20. The second shield electrode BMLa may be arranged corresponding to the oxide transistor O-TFT.

According to some embodiments of the present invention, the first shield electrode BMLa extends to the bottom of the oxide transistor O-TFT to replace the second shield electrode BMLb.

A third insulation layer 30 may be located on the second insulation layer 20. The second semiconductor pattern SC2 may be located on the third insulation layer 30. The second semiconductor pattern SC2 may include a channel area AC2 (hereinafter a second channel area) of the oxide transistor O-TFT. The second semiconductor pattern SC2 may include an oxide semiconductor. The second semiconductor pattern SC2 may include SnO₂, In₂O₃, IGZO, ZnO, ZnSnO (ZTO), or InZnO (IZO).

The oxide semiconductor may include a plurality of areas SE2, AC2, and DE2 divided according to whether a transparent conductive oxide is reduced. A zone (hereinafter, a reduction zone) in which the transparent conductive oxide is reduced has high conductivity in comparison to a zone (hereinafter, a non-reduction zone) in which the transparent conductive oxide is not reduced. The reduction zone may serve as a source/drain of the transistor or a signal line. The non-reduction zone substantially corresponds to a semiconductor area (or a channel) of the transistor. In other words, a portion of the second semiconductor pattern SC2 may be a semiconductor area of the transistor, another portion may be a source area SE2 (hereinafter a second source area)/drain area DE2 (hereinafter, second drain area) of the transistor, and still another portion may be a signal transfer area.

A fourth insulation layer 40 may be located on the third insulation layer 30. As shown in FIG. 4C, the fourth insulation layer 40 may cover the second semiconductor pattern SC2. According to some embodiments of the present invention, the fourth insulation layer 40 may be an insulation pattern that overlaps with the gate GT2 of the oxide transistor O-TFT and exposes the second source area SE2 and drain area DE2 of the oxide transistor O-TFT.

The gate GT2 of the oxide transistor O-TFT is located on the fourth insulation layer 40. The gate GT2 of the oxide transistor O-TFT may be partially a metal pattern. The gate GT2 of the oxide transistor O-TFT overlaps with the second channel area AC2.

A fifth insulation layer 50 may be located on the fourth insulation layer 40, and the fifth insulation layer 50 may cover the gate GT2 of the oxide transistor O-TFT. Each of the first to fifth insulation layers 10 to 50 may be an inorganic layer. As described above, the pixel driving circuit PC may be provided between the base layer 110 and the fifth insulation layer 50, or between the base layer 110 and a sixth insulation layer 60 to be described below.

A first connection electrode CNP1 or a first connection pattern CNP1 may be located on the fifth insulation layer 50. The first connection electrode CNP1 may be connected to the drain area DE1 of the silicon transistor S-TFT through a contact hole PCH1 (hereinafter, a first contact hole) penetrating through the first to fifth insulation layers 10, 20, 30, 40, and 50. According to some embodiments, another connection electrode may be located on the fifth insulation layer 50 to be connected to the first source area SE1 of the silicon transistor S-TFT through the first contact hole PCH1 penetrating through the first to fifth insulation layers 10, 20, 30, 40, and 50.

A second connection electrode CNP2 or a second connection pattern CNP2 may be located on the fifth insulation layer 50. The second connection electrode CNP2 may be provided through the same processes as the first electrode CNP1. The second connection electrode CNP2 may be connected to the second source area SE2 of the oxide transistor O-TFT through a contact hole PCH2 (hereinafter, a second contact hole) penetrating through the fourth and fifth insulation layers 40 and 50. According to some embodiments, another connection electrode may be located on the fifth insulation layer 50 to be connected to the second drain area DE2 of the oxide transistor O-TFT through the second contact hole PCH2 penetrating through the fourth and fifth insulation layers 40 and 50.

Opening BA-OP defining the boundary areas BA is provided in the laminate structure from the barrier layer 10br to the fifth insulation layer 50. The opening BA-OP provides valleys of the display panel DP. According to some embodiments, the opening BA-OP penetrate the barrier layer 10br to the fifth insulation layer 50 to expose the base layer 110.

According to some embodiments, the laminate structure with the opening BA-OP defined therein is defined as an inorganic laminate structure ISS. According to some embodiments, the inorganic laminate structure ISS may be a laminate structure of the barrier layer 10br to the fifth insulation layer 50. The inorganic laminate structure ISS may be an island structure.

The opening BA-OP have the shape corresponding to the boundary areas BA of FIG. 4B in a plan view. The opening BA-OP may divide the plurality of inorganic layers laminated in the whole display area DP-DA into a plurality of islands to suppress occurrence of cracks in the laminate structure. An impact applied externally is concentrated on the opening BA-OP, and thus a small amount of cracks may occur in the inorganic laminate structure. In addition, the opening BA-OP may prevent or reduce cracks occurring in a specific element area EA (see FIG. 4B) from extending to a nearby element area EA.

Referring to FIGS. 4B and 4C, the opening BA-OP are defined by inner surface I-S of the inorganic laminate structure ISS. The inner surface I-S of the inorganic laminate structure ISS may define a substantial polygonal shape including a vertex area having externally convex curves in a plan view.

An organic pattern ORP may be located on the base layer 110 in the opening BA-OP to contact the base layer 110. The organic pattern ORP fill the opening BA-OP and accordingly provide the relatively flat upper surface in subsequent processes. Namely, the sixth insulation layer 60 is provided on the relatively flat surface. However, the organic pattern ORP may not completely fill the opening BA-OP to expose a portion of the inner surface I-S.

The metal pattern MTP may be located on the organic pattern ORP and the fifth insulation layer 50. The metal pattern MTP contact all the top surfaces of the organic pattern ORP and the fifth inorganic insulation layer 50 in order to encapsulate the organic patterns OPR. The metal pattern MTP have the shape corresponding to the opening BA-OP in a plan view.

The metal pattern MTP may be provided in the same processes as the first connection electrode CNP1. The metal pattern MTP may include the same material and laminate structure as the first connection electrode CNP1.

Referring to FIG. 4D, the base layer 110 may include a first organic base layer 110-O1, which is termed as organic base layer in the claims, and a second organic base layer 110-02, which is termed as further organic base layer in the claims, that include organic materials and include an inorganic base layer 110-I located between the first organic base layer 110-O1 and the second organic base layer 110-O2 and including inorganic materials. FIG. 4D illustrates an example multilayer structure of the base layer 110, but the laminate structure of the base layer 110 is not limited thereto.

The opening BA-OP may extend to the second organic base layer 110-02 to enable the organic pattern ORP to contact the second organic base layer 110-02. Gases generated from the organic pattern ORP in the manufacturing process may be discharged via the second organic base layer 110-02. In FIG. 4D, a gas flow pump is shown by arrows. When gases generated from the organic pattern ORP in the manufacturing process is not discharged externally, the organic pattern ORP may expand to press the inner surface I-S of the inorganic laminate structure ISS and accordingly the inner surface I-S may be cracked. According to some embodiments, the gases may be smoothly discharged to suppress defects of the above-described crack occurrence.

The metal pattern MTP may contact the inorganic laminate structure ISS to encapsulate the organic pattern ORP. A portion of the metal pattern MTP contacts the upper surface of the inorganic laminate structure ISS, and the other of the metal pattern MTP contacts the inner surface I-S.

The metal pattern MTP may prevent or reduce instances of the gases generated by the organic pattern ORP flowing upwards. Accordingly, defects may be prevented or reduced, which occur when the gases oxidize the anode and/or cathode of the light-emitting element LD located in the upper side.

The metal pattern MTP may include multilayer metal layers in order to increase encapsulation efficiency. Even when the cracks occur in any one of the metal layers, the other metal layers may compensate the cracks and increase the encapsulation efficiency. The metal pattern MTP may have a three-layer structure of titanium layer/aluminum layer/titanium layer, but is not limited thereto.

In order to increase the encapsulation efficiency, the metal pattern MTP cover the boundary areas BA in a plan view as shown in FIG. 4E. Namely, in a plan view, the boundary areas BA are located inside the metal pattern MTP. The metal pattern MTP may include first portions P1 corresponding to the first boundary areas BA1 and second portions P2 corresponding to second boundary areas BA2.

In a plan view, it is sufficient for the metal pattern MTP to cover the boundary areas BA, and the metal pattern MTP expose a partial area of each of the first type element area EA1 and the second type element area EA2.

Referring to FIG. 4C, at least one organic layer is located on the fifth insulation layer 50. According to some embodiments, example three organic layers of a sixth insulation layer 60, a seventh insulation layer 70, and an eighth insulation layer 80 are illustrated.

The sixth insulation layer 60 may cover the fifth insulation layer 50 and the metal pattern MTP. A third connection electrode CNP3 may be located on the sixth insulation layer 60. The third connection electrode CNP3 may be connected to the first connection electrode CNP1 through a contact hole PCH3 (hereinafter, a third contact hole) penetrating through the sixth insulation layer 60. The data line DL may be located on the sixth insulation layer 60. The third connection electrode CNP3 and the data line DL are provided in the same processes and thus may have the same materials and laminate structure.

The seventh insulation layer 70 may be located on the sixth insulation layer 60, and cover the third connection electrode CNP3 and the data line DL. The eighth insulation layer 80 may be located on the seventh insulation layer 70.

The light-emitting element LD1 may include an anode AE (or a first electrode), a light-emitting layer EL, and a cathode CE (or a second electrode). The anode AE of the light-emitting element LD1 may be located on the eighth insulation layer 80. The anode AE may be a (semi-) transmissive electrode or a reflection electrode. The anode AE may include a laminate structure in which ITO/Ag/ITO are sequentially laminated. The positions of the anode AE and the cathode CE may be exchanged with each other. The anode AE may be connected to the third connection electrode CNP3 through a contact hole PCH4 (hereinafter, a fourth contact hole) penetrating through the seventh and eighth insulation layer 70 and 80.

A pixel definition layer PDL may be located on the eighth insulation layer 80. The pixel definition layer PDL may be an organic layer. The pixel definition layer PDL may have light absorption property and a black color. The pixel definition layer PDL may include a black coloring agent. The black coloring agent may include a black dye or a black pigment. The black coloring agent may include carbon black, a metal such as chromium, or an oxide thereof. The pixel definition layer PDL may correspond to a light shielding pattern having light shielding property.

The pixel definition layer PDL may cover a portion of the anode AE. For example, an opening PDL-OP configured to expose a portion of the anode AE may be defined in the pixel definition layer PDL. The emission area LA may be defined to correspond to the opening PDL-OP. According to some embodiments of the present invention, a hole control layer may be located between the anode AE1 and the light-emitting layer EL. The hole control layer may include a hole transport layer and further include a hole injection layer. An electron control layer may be located between the light-emitting layer EL and the cathode CE. The electron control layer may include an electron transport layer and further include an electron injection layer. The cathode CE may receive the second power supply voltage ELVSS (see FIG. 4A).

The encapsulation layer 140 may cover the light-emitting element LD. The encapsulation layer 140 may include an inorganic encapsulation layer 141, an organic encapsulation layer 142, and an inorganic encapsulation layer 143 that are sequentially laminated, but the layers configuring the encapsulation layer 140 are not necessarily limited thereto. Each of the inorganic encapsulation layers 141 and 143 may include a silicon nitride layer, a silicon oxynitride layer, a silicon oxide layer, a titanium oxide layer, an aluminum oxide layer or the like. Each of the inorganic encapsulation layers 141 and 143 may also have a multilayer structure. The organic encapsulation layer 142 may include an acrylic-based organic layer, but is not limited thereto.

The input sensor ISP may be located on the display panel DP. The input sensor ISP may include at least one conductive layer and at least one insulation layer. According to some embodiments, the input sensor ISP may include a first insulation layer 210, a first conductive layer 220, a second insulation layer 230, a second conductive layer 240, and a third insulation layer 250. At least one of the first insulation layer 210 or the third insulation layer 250 may be omitted.

The first insulation layer 210 may be directly located on the display panel DP. The first insulation layer 210 may be an inorganic layer including any one among silicon nitride, silicon oxynitride, or silicon oxide. Each of the first conductive layer 220 and the second conductive layer 240 may have a single layer structure or a multilayer structure laminated along the third direction DR3. Each of the first conductive layer 220 and the second conductive layer 240 may include conductive lines defining an electrode of a mesh shape. The conductive lines of the first conductive layer 220 and the conductive lines of the second conductive layer 240 may be or may not be connected through a contact hole penetrating the second insulation layer 230. Depending on the type of a sensor provided with the input sensor ISP, a connection relationship may be determined between the conductive lines of the first conductive layer 220 and the conductive lines of the second conductive layer 240.

Each of the first conductive layer 220 and the second conductive layer 240 of single layer structures may include a metal layer or a transparent conductive layer. The metal layer may include molybdenum, silver, titanium, copper, aluminum, or an alloy thereof. The transparent conductive layer may include a transparent conductive oxide such as indium tin oxide (ITO), Indium zinc oxide (IZO), zinc oxide (ZnOx), or indium-zinc-tin oxide (IZTO). Besides, the transparent conductive layer may include a conductive polymer such as PEDOT, a metal nano-wire, or graphene.

Each of the first conductive layer 220 and the second conductive layer 240 of multilayer structure may include metal layers. For example, the metal layers may have a three-layer structure of titanium/aluminum/titanium. The conductive layer of the multilayer structure may include at least one metal layer and at least one transparent conductive layer. The second insulation layer 230 may be located between the first conductive layer 220 and the second conductive layer 240.

The anti-reflection layer ARL may be located on the input sensor ISP. The anti-reflection layer ARL may include a division layer 310, a color filter 320, and a planarization layer 330.

A material composing the division layer 310 may be used without limitation as long as the material absorbs light. The division layer 310 is a layer having black color and, according to some embodiments, may include a black coloring agent. The black coloring agent may include a black dye or a black pigment. The black coloring agent may include carbon black, a metal such as chromium, or an oxide thereof.

The division layer 310 may cover the second conductive layer 240 of the input sensor ISP. The division layer 310 may prevent or reduce reflection of external light due to the second conductive layer 240. An opening 310-OP may be defined in the division layer 310. The opening 310-OP may overlap with the anode AE1.

The color filter 320 may overlap with the opening 310-OP. The color filter 320 may overlap with the light-emitting element LD1 in the lower side. The color filter 320 may contact the division layer 310.

The planarization layer 330 may cover the division layer 310 and the color filter 320. The planarization layer 330 may include an organic material and provide a planar surface on the upper surface of the planarization layer 330. According to some embodiments of the present invention, the planarization layer 330 may be omitted.

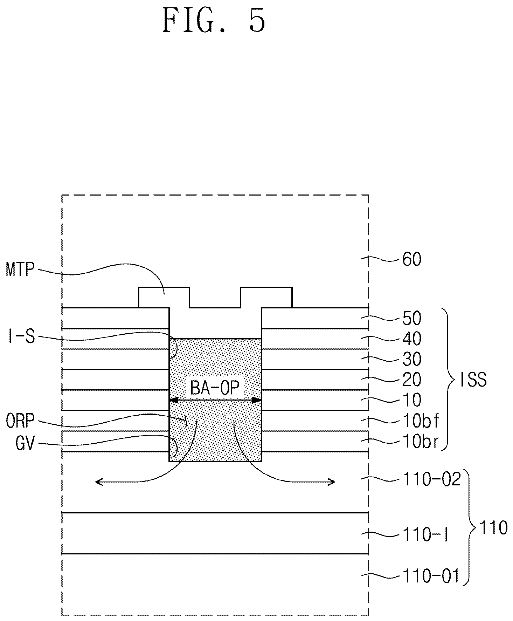

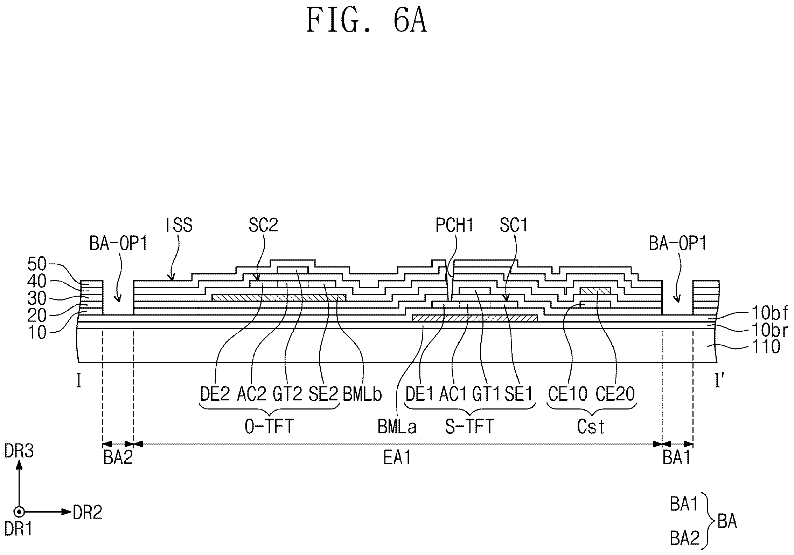

FIG. 5 is an enlarged cross-sectional view of the display panel DP according to some embodiments of the present invention. FIGS. 6A to 6D are cross-sectional views showing a manufacturing process of the display panel DP according to some embodiments of the present invention. FIGS. 6A to 6D are illustrated on the basis of FIG. 5. Hereinafter, some detailed description about like components to those described with reference to FIGS. 4A to 4D may be omitted.

As shown in FIG. 5, a groove GV extending from the opening BA-OP may be defined in the second organic base layer 110-02. The organic pattern ORP may be further located in the groove GV.

As shown in FIG. 6A, the layers up to the fifth insulation layer 50 are provided on the base layer 110 and then the first contact hole PCH1 is provided. A photoresist is provided on the fifth insulation layer 50 and then the first contact hole PCH1 penetrating through the first to fifth insulation layers 10 to 50 is provided through exposure, development, and etching processes.

Preliminary opening BA-OP1 is provided in the same processes as the processes for providing the first contact hole PCH1. The preliminary opening BA-OP1 overlapping with the boundary areas BA are provided. The preliminary opening BA-OP1 also penetrate through the first to fifth insulation layers 10 to 50.

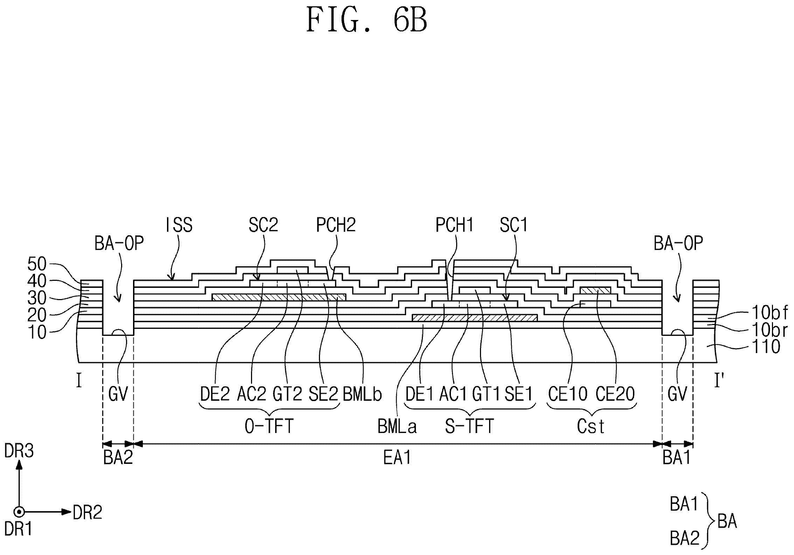

As shown in FIG. 6B, following the providing of the photoresist, the second contact hole PCH2 penetrating through the fourth and fifth insulation layers 40 and 50 is provided through exposure, development, and etching processes.

The opening BA-OP are provided from the preliminary opening BA-OP1 in the same processes as the processes for providing the second contact hole PCH2. The opening BA-OP become deeper than the preliminary opening BA-OP1 by further removing the buffer layer 10bf and the barrier layer 10br.

While the second contact hole PCH2 is provided, the second semiconductor pattern SC2 serves as an etching stopper. However, the etching stopper is not located in the boundary areas BA, and accordingly more etching is performed. Therefore, the groove GV extending from the opening BA-OP may be provided in the base layer 110. The depth of the groove GV is not particularly limited. As described with reference to FIG. 5, the groove GV may be provided in a portion of the second organic base layer 110-02, or penetrate through the second organic base layer 110-02.

The second contact hole PCH2 is shallow due to penetrating through fewer inorganic layers than the first contact hole PCH1. The opening BA-OP is provided through two etching processes for providing the first contact hole PCH1 and the second contact hole PCH2, and thus is deeper than the first contact hole PCH1 and the second contact hole PCH2.

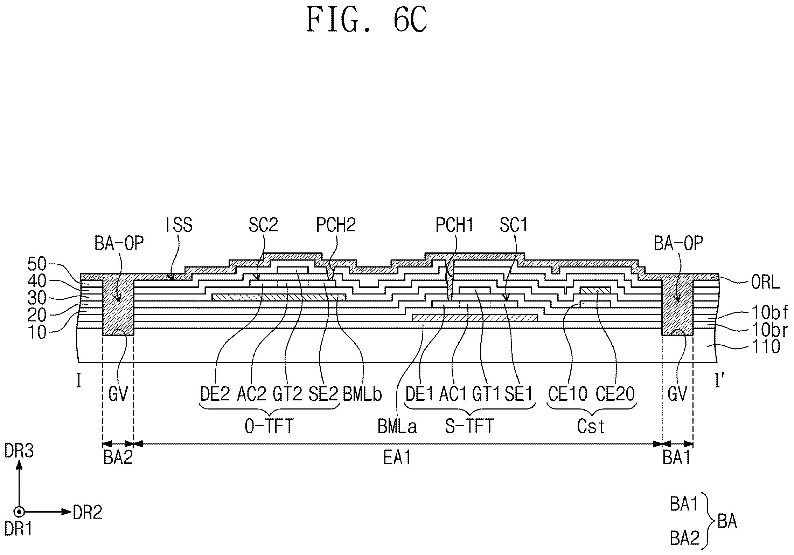

As shown in FIG. 6C, an organic layer ORL covering the fifth insulation layer 50 is provided on the base layer 110. The organic layer ORL may be provided in a coating process. The organic layer ORL may fill the opening BA-OP and the groove GV. Here, the organic layer ORL may further fill the first contact hole PCH1 and the second contact hole PCH2.

Following providing of the photoresist layer on the organic layer ORL, the organic layer ORL is patterned through exposure, development, and etching processes. In the exposure process, a halftone mask may be used. Depending on the property of the photoresist layer, only an area overlapping with the opening BA-OP may be further or less exposed.

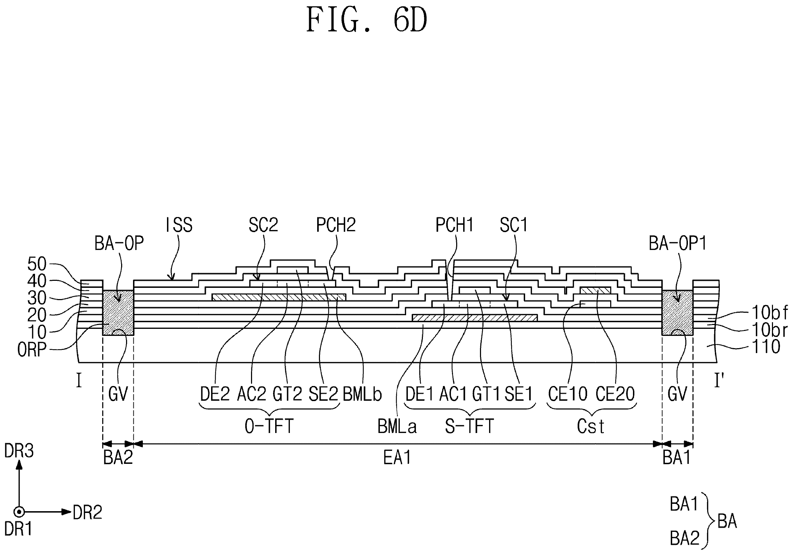

As shown in FIG. 6D, the organic pattern ORP may be provided from the organic layer ORL of FIG. 6C. The organic pattern ORP may fill the opening BA-OP and the groove GV. The organic pattern ORP does not fill the opening BA-OP completely. For example, the organic pattern ORP may underfill the opening BA-OP by 100 nm (1000 Å) to 300 nm (3000 Å) (or about 100 nm (1000 Å) to about 300 nm (3000 Å)). Accordingly, the metal pattern MTP (see FIG. 4C) generated in the subsequent processes are partially inserted into the opening BA-OP to further increase the encapsulation efficiency of the metal pattern MTP.

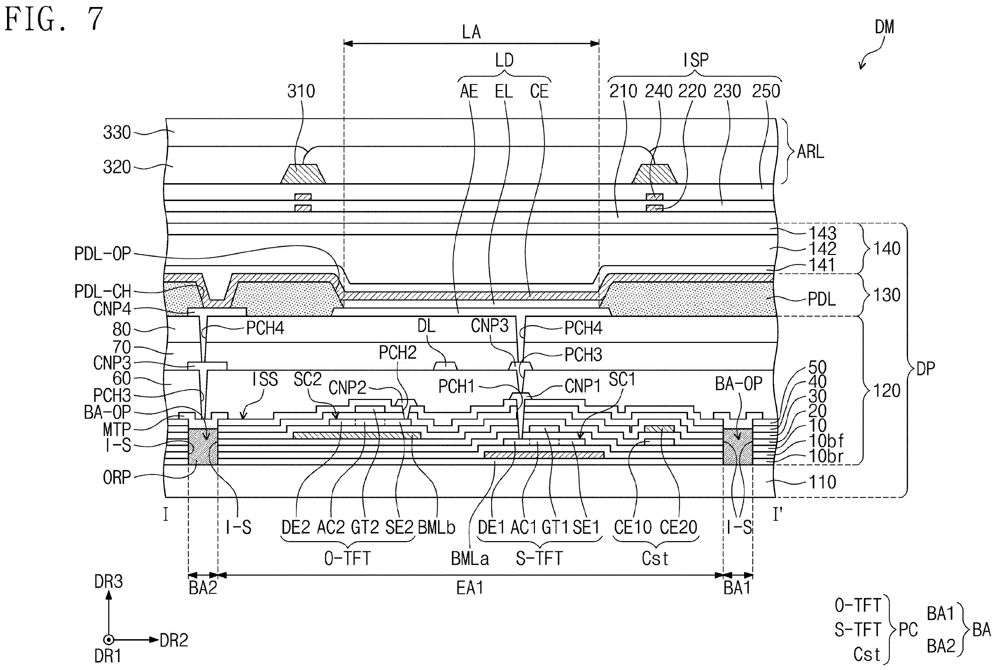

FIG. 7 is a cross-sectional view of the display module DM according to some embodiments of the present invention. Hereinafter, some detailed description of like components to those described with reference to FIGS. 4A to 4D may be omitted.

As shown in FIG. 4E, the metal pattern MTP including the first portions P1 and the second portions P2 may be located in the whole display area DP-DA shown in FIG. 3. The metal pattern MTP may receive a prescribed voltage. According to some embodiments, the metal pattern MTP may receive the second power supply voltage ELVSS (see FIG. 4A).

As shown in FIG. 7, the cathode CE may be electrically connected to the metal pattern MTP. The third connection electrode CNP3 may be located on the sixth insulation layer 60 and connected to the metal pattern MTP through the third contact hole PCH3. A fourth connection electrode CNP4 may be located on the eighth insulation layer 80 and connected to the third connection electrode CNP3 through the fourth contact hole PCH4. The cathode CE may be connected to the fourth connection electrode CNP4 through a contact hole PDL-CH (or an opening) provided in the pixel definition layer PDL. According to some embodiments of the present invention, the number of connection electrodes located between the cathode CE and the metal pattern MTP may be further added or partially omitted.

A plurality of connection structures between the cathode CE and the metal pattern MTP as shown in FIG. 7 may be located regularly across the display area DP-DA shown in FIG. 3. The cathode CE and the metal pattern MTP may be connected in the plurality of areas and thereby prevent or reduce instances of a voltage drop of the second power supply voltage ELVSS being transferred to the cathode CE.

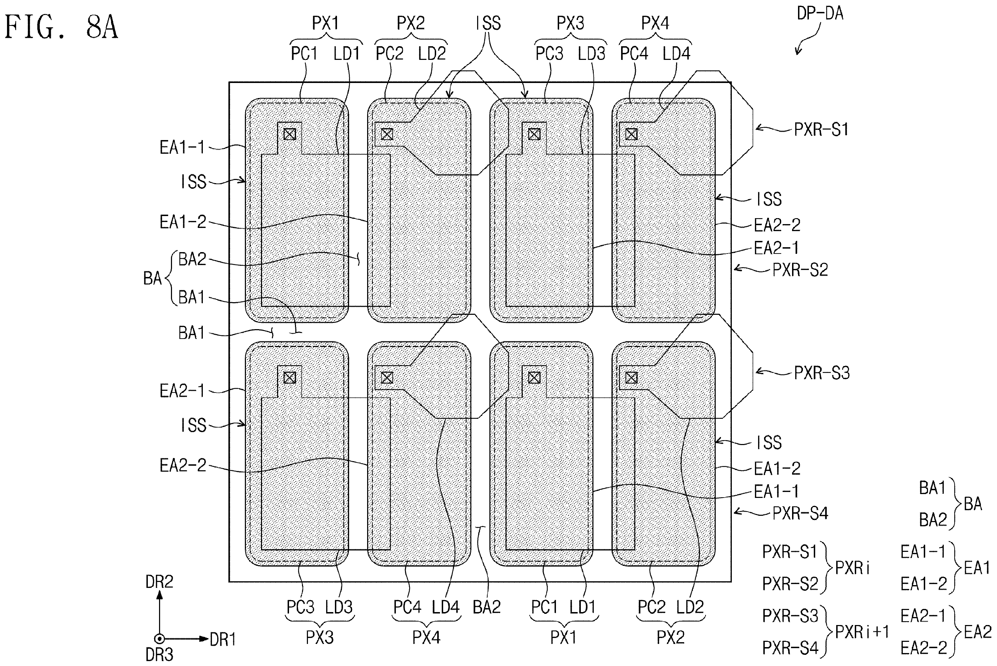

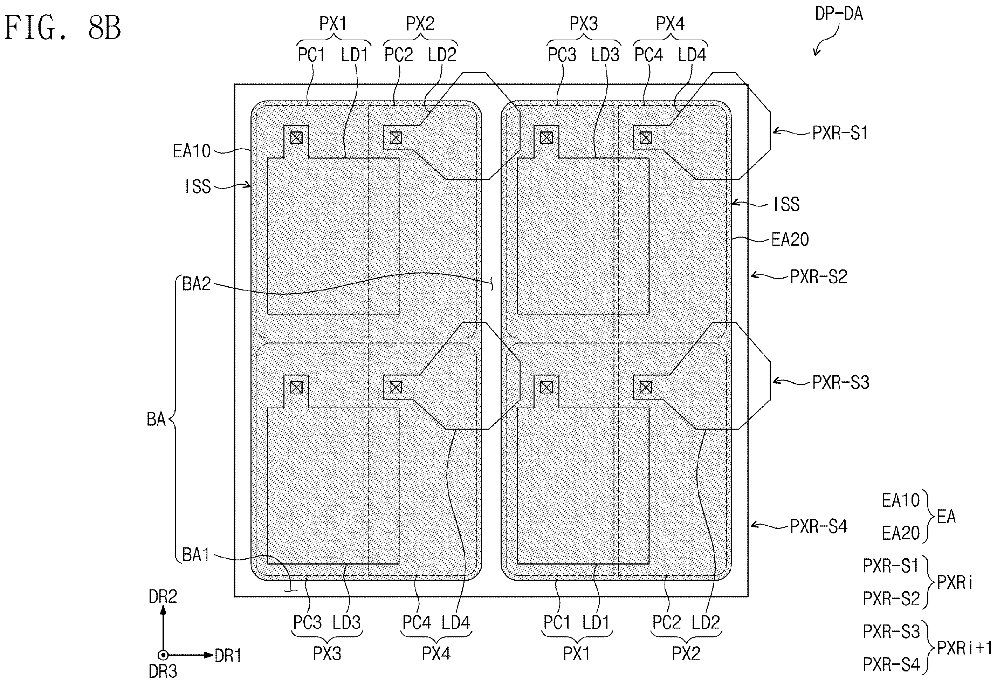

FIGS. 8A and 8B are plan views of the display area DP-DA according to some embodiments of the present invention. Hereinafter, detailed description of like components to those described with reference to FIGS. 4A to 4C will be omitted.

Referring to FIG. 8A, unlike FIG. 4B, the first type element areas EA1 may be divided by the second boundary areas BA2 into a first partial element area EA1-1 and a second partial element area EA1-2, and the second type element areas EA2 may be divided by the second boundary areas BA2 into a third partial element area EA2-1 and a fourth partial element area EA2-2. The inorganic laminate structure ISS described with reference to FIG. 4C may be located in each of the first partial element area EA1-1, the second partial element area EA1-2, the third partial element area EA2-1, and the fourth partial element area EA2-2.

The first to fourth light-emitting elements LD1, LD2, LD3 and LD4 may overlap with the boundary areas BA. As described with reference to FIG. 4C, the first to fourth light-emitting elements LD1, LD2, LD3 and LD4 are located on the eighth insulation layer 80, and thus the boundary areas BA do not limit the design of the first to fourth light-emitting elements LD1, LD2, LD3 and LD4.

Referring to FIG. 8B, unlike FIG. 4B, a first pixel PX1 and a second pixel PX2 of the i-th pixel row PXRi, and a third pixel PX3 and a fourth pixel PX4 of the (i+1)-th pixel row PXRi+1 may be located in the first type element area EA10. A third pixel PX3 and a fourth pixel PX4 of the i-th pixel row PXRi and a first pixel PX1 and a second pixel PX2 of the (i+1)-th pixel row PXRi+1 may be located in the second type element area EA20. The inorganic laminate structure ISS may be located in each of the first type element area EA10 and the second type element area EA20.

According to some embodiments of the present invention, openings defined in the inorganic layers provide the valleys along the display panel to divide the laminate structure of the inorganic layers into island structures. The valleys relatively improve the flexibility of the display panel and the impact resistance.

The openings extend to the base layer located on the bottom. The gases generated from the organic patterns located in the openings during the manufacturing process may be discharged via the base layer. Accordingly, defects due to cracks occurring on the inner surfaces of the inorganic layers due to expansion of the organic patterns may be suppressed.

The metal pattern encapsulates the organic patterns located in the openings. The gases generated from the organic patterns located in the openings during the manufacturing process are not provided to the light-emitting elements located in a top side. Therefore, oxidation of the electrodes of the light-emitting elements may be prevented or reduced to suppress dark spot defects.

While aspects of some embodiments of the present invention have been described with reference to aspects of some embodiments thereof, it will be clear to those of ordinary skill in the art to which the invention pertains that various changes and modifications may be made to the described embodiments without departing from the technical area of the invention as defined in the appended claims.

Thus, the scope of embodiments according to the present invention shall not be restricted or limited by the foregoing description, but be determined by the broadest permissible interpretation of the following claims.

## Claims

1. A display device (DD) comprising:
an organic base layer (110-02) comprising a plurality of element areas (EA) and a boundary area (BA) between the plurality of element areas (EA);
a plurality of inorganic layers on the organic base layer (110-02) and having an opening (BA-OP) defined therein, the opening (BA-OP) exposing the organic base layer (110-02) and corresponding to the boundary area (BA);
an organic pattern (ORP) in the opening (BA-OP) and contacting the organic base layer (110-02);
a metal pattern (MTP) partially inside the opening (BA-OP) to contact the organic pattern (ORP) and on the plurality of inorganic layers;
at least one organic layer covering the metal pattern (MTP) and on the plurality of inorganic layers;
a first transistor (S-TFT) and a second transistor (O-TFT) between the organic base layer (110-02) and the at least one organic layer and in each of the plurality of element areas (EA); and
a light-emitting element (LD) on the at least one organic layer and electrically connected to at least the first transistor (S-TFT) or the second transistor (O-TFT).

2. The display device (DD) of claim 1, wherein the plurality of inorganic layers comprises an inorganic laminate structure in each of the plurality of element areas (EA) and defined by the opening (BA-OP) and the opening (BA-OP) surrounds the inorganic laminate structures in a plan view.

3. The display device (DD) of claim 1 or 2, wherein
each of the plurality of element areas (EA) comprises a first pixel area (PXA1) and a second pixel area (PXA2),
the first transistor (S-TFT) and the second transistor (O-TFT) is in each of the first pixel area (PXA1) and the second pixel area (PXA2), and
the light-emitting element (LD) is in each of the first pixel area (PXA1) and the second pixel area (PXA2).

4. The display device (DD) of at least one of claims 1 to 3, wherein the light-emitting element (LD) overlaps the opening (BA-OP) in a plan view.

5. The display device (DD) of at least one of claims 1 to 4, further comprising:
an inorganic base layer (110-I) under the organic base layer (110-02); and
a further organic base layer (110-O1) under the inorganic base layer (110-I),
wherein a groove (GV) extending from the opening (BA-OP) is defined in the organic base layer (110-02).

6. The display device (DD) of claim 5, wherein the organic pattern (ORP) is in the groove (GV).

7. The display device (DD) of at least one of claims 1 to 6, wherein
the plurality of inorganic layers comprises inner surface defining the opening (BA-OP), and
the metal pattern (MTP) contacts the inner surface and an upper surface of a top inorganic layer of the plurality of inorganic layers.

8. The display device (DD) of at least one of claims 1 to 7, wherein
the first transistor (S-TFT) comprises a silicon semiconductor pattern comprising a first input area, a first output area, and a first channel area (AC1) between the first input area and the first output area, and
the second transistor (O-TFT) comprises an oxide semiconductor pattern comprising a second input area, a second output area, and a second channel (AC2) area between the second input area and the second output area.

9. The display device (DD) of claim 8, wherein
the silicon semiconductor pattern and the oxide semiconductor pattern are at different layers among the plurality of inorganic layers, and
a first contact hole (PCH1) exposing the first input area or the first output area and a second contact hole (PCH2) exposing the second input area or the second output area are defined in the plurality of inorganic layers.

10. The display device (DD) of claim 9, wherein
the first contact hole (PCH1) is deeper than the second contact hole (PCH2), and
the opening (BA-OP) is deeper than the first contact hole (PCH1) and the second contact hole (PCH2).

11. The display device (DD) of claim 9 or 10, further comprising:
a first connection electrode (CNP1) on the plurality of inorganic layers and connected to the first input area or the first output area through the first contact hole (PCH1); and
a second connection electrode (CNP2) on the plurality of inorganic layers and connected the second input area or the second output area through the second contact hole (PCH2).

12. The display device (DD) of claim 11, wherein the first connection electrode (CNP1), the second connection electrode (CNP2), and the metal pattern (MTP) have a same laminate structure.

13. The display device (DD) of at least one of claims 1 to 12, wherein the metal pattern (MTP) comprises multilayer metal layers.

14. The display device (DD) of at least one of claims 1 to 13, wherein in a plan view, the metal pattern (MTP) covers the boundary area (BA) and expose a partial area of each of the plurality of element areas (EA).

15. The display device (DD) of at least one of claims 1 to 14, further comprising:
a thin-film encapsulation layer (140) covering the light-emitting element (LD);
an input sensor (ISP) on the thin-film encapsulation layer (140); and
a color filter (320) on the input sensor (ISP) and overlapping with the light-emitting element (LD).
